# EUROPÄISCHE PATENTSCHRIFT

(11) **EP 0 573 804 B1**
(45) Veröffentlichungstag und Bekanntmachung des Hinweises auf die Patenterteilung: **12.03.1997**
(21) Anmeldenummer: 93107783.8
(22) Anmeldetag: 13.05.1993
(51) Int. Cl.: C04B 35/00, C04B 35/653, C04B 35/64

(54) **Oxidkeramisches Supraleitermaterial und Verfahren zu seiner Herstellung**
Oxide-ceramic superconducting material and process of fabrication thereof
Matériau supraconducteur de céramique oxydée et son procédé de fabrication

(30) Priorität: 09.06.1992 DE 4218864
(43) Veröffentlichungstag der Anmeldung: 15.12.1993
(73) Patentinhaber: Vacuumschmelze GmbH, 63450 Hanau (DE)
(72) Erfinder: Tenbrink, Johannes, Dr., W-8752 Mömbris (DE); Heine, Klaus, Dr., W-6053 Obertshausen (DE); Puniska, Paul, W-6451 Neuberg 1 (DE); Glücklich, Volker, W-6451 Hammersbach (DE)
(74) Vertreter: Fuchs, Franz-Josef, Dr.-Ing.

(56) Entgegenhaltungen:
- EP-A- 0 292 340
- EP-A- 0 303 249
- WO-A-92/03390
- FR-A- 2 659 640
- THIN SOLID FILMS, Bd.228, Nr.1-2, 15. Mai 1993, LAUSANNE CH Seiten 196 - 200 E.W. SEIBT ET AL 'Effects of carbon impurities in high Tc superconducting tapes using Auger electron spectroscopy.'
- SUPERCONDUCTOR SCIENCE AND TECHNOLOGY, Bd.3, Nr.8, August 1990, BRISTOL GB Seiten 391 - 394 E.K. CHANG ET AL 'The effect of CO2 in the processing atmosphere of YBa2Cu3Ox.'
- DATABASE WPI Section Ch, Week 9051, Derwent Publications Ltd., London, GB; Class L03, AN 90-380369 & JP-A-2 275 799 (HITACHI KK) 9. November 1990
- DATABASE WPI Section Ch, Week 9123, Derwent Publications Ltd., London, GB; Class L03, AN 91-169050 & JP-A-3 103 321 (HITACHI CHEMICAL KK) 30. April 1991
- PATENT ABSTRACTS OF JAPAN vol. 015, no. 221 (C-0838) 6. Juni 1991 & JP-A-03 065 513 (HITACHI CHEM CO LTD) 20. März 1991
- MATERIALS LETTERS, Bd.9, Nr.10, Juni 1990, AMSTERDAM NL Seiten 347 - 352 Y. GAO ET AL 'Jc degradation of YBa2Cu3O7-x superconductors sintered in CO2/O2.'
- IEEE TRANSACTIONS ON MAGNETICS, Bd.27, Nr.2, März 1991, NEW YORK US Seiten 1239 - 1246 J. TENBRINK ET AL 'Development of high-Tc superconductor wires for magnet applications.'

## Beschreibung

Die Erfindung betrifft ein oxidkeramisches Supraleitermaterial mit einer Sprungtemperatur von mehr als 77 K und einer Zusammensetzung, die im wesentlichen die Elemente Bi, Sr, Ca, Cu, O enthält und weiterhin einen geringen Anteil an Kohlenstoff aufweist, der im Gleichgewichtszustand zwischen 200 bis 800 ppmw beträgt. Weiterhin betrifft die Erfindung ein Verfahren zur Herstellung eines oxidkeramischen Supraleitermaterials.

Aus EP-A-303249 sind Supraleiter bekannt, die Bi, Sr, Ca, Cu und O enthalten und deren Kohlenstoffbereich innerhalb von 200 bis 800 ppmw liegt. Soweit es sich um Supraleiter mit Bi, Sr, Ca, Cu und O handelt, wird dieser Kohlenstoffgehalt nur eingestellt bei einem atomaren Mischungsverhältnis der Elemente Bi, Sr, Ca, Cu von 1112.

Bei Herstellung des Supraleitermaterials auf pulvermetallurgischem Wege mit einer supraleitenden Phase, die im wesentlichen die Zusammensetzung Bi2Sr2Ca1Cu2O8 (Bi2212) oder Bi2Sr2Ca2Cu3O8 (Bi2223) enthält, wird von Oxiden oder Carbonaten der metallischen Bestandteile des Supraleitermaterials ausgegangen. Diese werden zunächst innig miteinander vermischt und anschließend einem Umsatzbrand unterzogen, der in der Regel mehrstufig erfolgt. Durch die Verwendung von Carbonaten wird Kohlenstoff in die Verbindung miteingebracht. Während des Umsatzbrandes erfolgt ein weitgehender Abbau des Kohlenstoffgehaltes. Dies war erwünscht, da der Kohlenstoff als Verunreinigung angesehen wurde, durch die die erreichbare Stromdichte begrenzt wird (Flükiger et al. in SUPERCOND. SCI. TECHN., 5 (1991) S. 61). Der Abbau des Kohlenstoffs während des Umsatzbrandes wird aus einem Beispiel in der Veröffentlichung von Tenbrink et al. in IEEE Trans. Magn. 27 (1991), 1239 deutlich. Dort betrug der Kohlenstoffgehalt in der Ausgangsmasse 24600 ppmw (ppm by weight). Nach Durchführung des dreistufigen Umsatzbrandes betrug der Kohlenstoffgehalt im Gleichgewichtszustand dann jedoch weniger als 200 ppmw.

Aus der Zeitschrift SUPERCOND. SCI. TECHN., 3 (1990) S. 391 - 394 ist es bekannt, bei YBaCuO-Supraleitern eine Wärmebehandlung in einer CO2-reichen Atmosphäre durchzuführen, um den Kohlenstoffgehalt zu erhöhen. Aus der Zeitschrift Materials Letters, Vol. 9, Nr. 10 Juni 1990, Seiten 347 - bis 352 geht hervor, daß bei der Sinterung des YBaCuO-Pulvers eine Sinterung in sauerstoffhaltiger Atmosphäre durchgeführt wird, der ein Anteil von 0 bis 5 % CO2 beigemischt ist. Aus JP-2-275799 geht hervor, daß man ein Gemisch aus Ar mit CO2 im Verhältnis 10:1 bei 850°C zur Kristallisation von BiPbSrCaCuO - Supraleitern verwenden kann.

Aufgabe der Erfindung ist es, ein oxidkeramisches Supraleitermaterial anzugeben, das eine besonders kritische Stromdichte aufweist.

Die Aufgabe wird durch ein Supraleitermaterial gelöst, das die Merkmale des Anspruch 1 besitzt.

Überraschenderweise wurde somit gefunden, daß eine Erhöhung der kritischen Stromdichte auch dann erreicht wird, wenn man ein Supraleitermaterial mit im wesentlichen den Elementen Bi, Sr, Ca, Cu und O mit einem Kohlenstoffgehalt im Gleichgewichtszustand zwischen 200 bis 800 ppmw herstellt und dazu eine supraleitende Phase verwendet, die im wesentlichen die Zusammensetzung Bi2Sr2Ca1Cu2O8 (Bi2212) oder Bi2Sr2Cr2Cu3O8 (Bi2223) aufweist.

Dabei kann zur Erzielung eines dreischichtigen Aufbaus, also eines Aufbaus mit 3 Cu-0-Ebenen das Bi teilweise durch Pb ersetzt werden.

Die Einstellung des Kohlenstoffgehaltes bei dem erfindungsgemäßen Supraleitermaterial kann beispielsweise erreicht werden, wenn der Umsatzbrand vorzeitig abgebrochen wird. Dieser Zustand ist jedoch nicht erwünscht, da sich das Supraleitermaterial nach unvollständigem Umsatzbrand nicht im Gleichgewichtszustand befindet. Zur Einstellung des erforderlichen Kohlenstoffgehaltes im Gleichgewichtszustand wird daher in einer weiteren Glüh- oder Schmelzbehandlung eine Atmosphäre verwendet, deren CO2-Gehalt höher als der von Luft ist. Außer Luft kann auch eine Atmosphäre mit Argon oder Stickstoff zur Anwendung kommen. Der Umsatzbrand wird in der Regel mehrstufig durchgeführt, wobei zwischen den einzelnen Stufen das Material jeweils zerkleinert wird.

Die Erfindung wird im folgenden anhand der Ausführungsbeispiele und der Figuren beschrieben. Es zeigen:
- Fig. 1: die Abhängigkeit der Stromdichte vom Kohlenstoffgehalt,
- Fig. 2: die Abhängigkeit des Kohlenstoffgehaltes vom Kohlendioxidgehalt der Atmosphäre beim Schmelzen von Bi2212 - Material bei ca. 1050 °C.

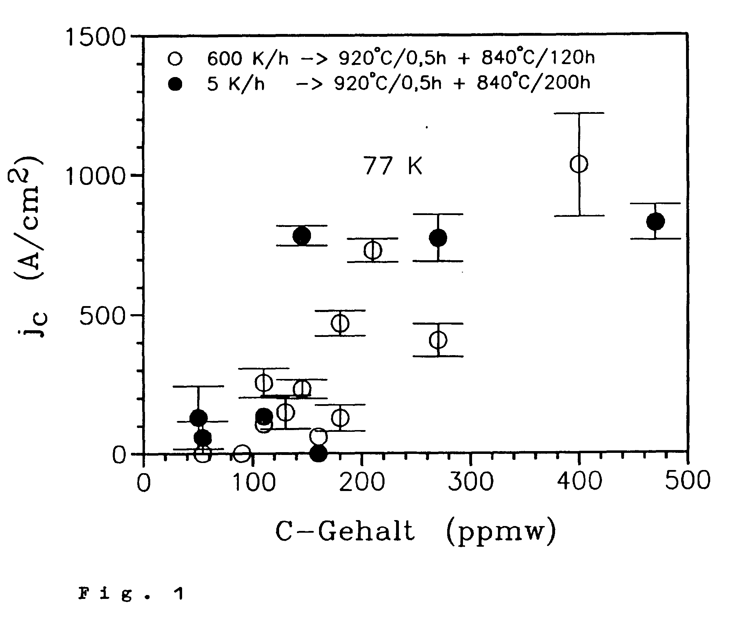

In Ausführungsbeispielen wurden ausgehend von Bi₂O₃-, CaCO₃- bzw. CaO-, SrCO₃- und CuO-Pulvern Bi-Ca-Sr-Cu-O-Supraleitermaterialien hergestellt. Hierzu wurden die Ausgangspulver zunächst innig miteinander vermischt und dann einem dreistufigen Umsatzbrand bei Temperaturen zwischen 800 und 850 °C unterzogen. Der Umsatzbrand erfolgte zumindest teilweise in einer erfindungsgemäßen CO₂-haltigen Atmosphäre. Mit den so hergestellten Supraleitermaterialien wurden Supraleiterdrähte nach der sogenannten Pulver-in-Rohr-Technik hergestellt, wobei Pulver des Supraleitermaterials in Röhrchen aus Silber oder einer Silberlegierung eingefüllt und diese zu einem Draht weiterverarbeitet wurden. Eine abschließende Wärmebehandlung diente insbesondere zur Einstellung des Sauerstoffgehaltes in an sich bekannter Weise. An den so gewonnenen Proben wurde die Abhängigkeit der kritischen Stromdichte vom Kohlenstoffgehalt des Supraleitermaterials bestimmt. Die Ergebnisse sind in Fig. 1 dargestellt. Die Parameter der abschließenden Wärmebehandlung sind in der Fig. 1 mit angegeben. Wie aus der Figur zu ersehen ist, wird mit Kohlenstoffgehalten von mehr als 200 ppmw ein Anstieg der kritischen Stromdichte, die bei einer Temperatur von 77 K bestimmt wurde, erreicht. Bei einem Restkohlenstoffgehalt von 940 ppmw wurden kritische Stromdichten unterhalb von 100 A/cm² erzielt (nicht eingezeichnet).

Um den Zusammenhang zwischen dem Kohlenstoffgehalt des Supraleitermaterials und dem Kohlendioxidgehalt in der Atmosphäre des Umsatzbrandes bzw. einer weiteren Glühung zu bestimmen, wurden zusätzliche Versuche durchgeführt. Hierbei wurden Supraleitermaterialien aus den oben angegebenen Ausgangspulvern hergestellt. Die einzelnen Stufen des Umsatzbrandes wurden unter Luft bzw. Argon-Atmosphäre durchgeführt, so daß das Pulver im Gleichgewichtszustand schließlich einen Kohlenstoffgehalt von 100 ppmw aufwies. Das so erhaltene Pulver wurde in verschiedenen Versuchen in einer Atmosphäre mit unterschiedlichen CO₂-Gehalten bei ca. 1050 °C geschmolzen und dann abgegossen. Die Atmosphäre bei diesem Schmelzprozeß bestand entweder aus Luft, aus Luft, die zusätzlich mit CO₂ angereichert wurde, oder aus einem Gemisch von Argon und CO₂.

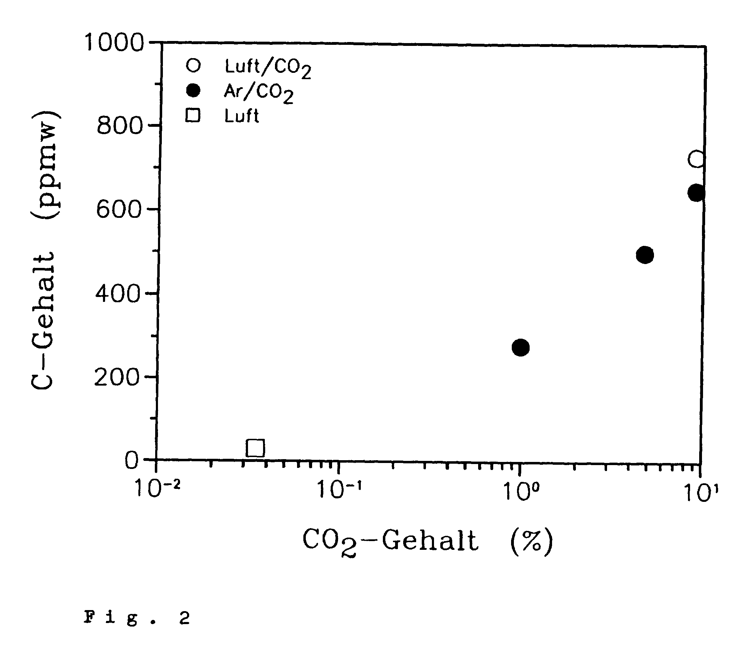

Der Zusammenhang zwischen dem Kohlenstoffgehalt des Supraleitermaterials und dem Kohlendioxidgehalt der Atmosphäre während des Schmelzens ist in Fig. 2 aufgetragen. Wird die Behandlung nur an Luft mit einem CO₂-Gehalt von ca. 0,035 % durchgeführt, so liegt der Kohlenstoffgehalt bei ca. 30 ppmw. Erst bei Verwendung einer mit Kohlendioxid angereicherten Atmosphäre wird im Supraleitermaterial auch im Gleichgewichtszustand ein Kohlenstoffgehalt von 200 bis 800 ppmw erreicht. Vorzugsweise sollte der CO₂-Gehalt der Atmosphäre zwischen 0,1 und 20 % betragen, wenn wie hier bei Temperaturen oberhalb 1000 °C geschmolzen wird. Für niedrigere Temperaturen, z. B. bei einem gewöhnlichen Umsatzbrand zwischen 800 und 860 °C, liegen die benötigten CO₂-Gehalte der Atmosphäre aus thermodynamischen Gründen niedriger und sollten vorzugsweise nicht mehr als 5 % betragen.

Gemäß der Erfindung wird somit durch kontrollierte Einstellung des Kohlenstoffgehalts im Supraleitermaterial eine Erhöhung der kritischen Stromdichte erreicht.

## Patentansprüche

1. Oxidkeramisches Supraleitermaterial mit einer Sprungtemperatur von mehr als 77 K und einer Zusammensetzung, die im wesentlichen die Elemente Bi, Sr, Ca, Cu, O enthält und weiterhin einen geringen Anteil an Kohlenstoff aufweist, der im Gleichgewichtszustand zwischen 200 bis 800 ppmw beträgt, **dadurch gekennzeichnet,** daß die supraleitende Phase des Supraleitermaterials im wesentlichen die Zusammensetzung Bi2Sr2Ca1Cu2O8 (Bi2212) oder die Zusammensetzung Bi2Sr2Ca2Cu3O8 (Bi2223) aufweist.

2. Supraleitermaterial nach Anspruch 1, **dadurch gekennzeichnet**, daß Bi teilweise durch Pb ersetzt ist.

## Claims

1. Oxide ceramic superconductor material having a critical temperature in excess of 77 K and a composition which essentially contains the elements Bi, Sr, Ca, Cu, O and furthermore has a low proportion of carbon, which is between 200 and 800 ppmw in the equilibrium state, characterized in that the superconducting phase of the superconductor material essentially has the composition Bi2Sr2CalCu2O8 (Bi2212) or the composition Bi2Sr2Ca2Cu3O8 (Bi2223).

2. Superconductor material according to Claim 1, characterized in that Bi is partially replaced by Pb.

## Revendications

1. Matériau supraconducteur de céramique oxydée avec une température critique supérieure à 77 K et avec une composition qui contient essentiellement les éléments Bi, Sr, Ca, Cu, O et qui présente en outre une faible teneur en carbone, qui vaut, à l'état d'équilibre, entre 200 et 800 ppmw, caractérisé en ce que la phase supraconductrice du matériau supraconducteur présente essentiellement la composition Bi2Sr2Ca1Cu2O8 (Bi2212) ou la composition Bi2Sr2Ca2Cu3O8 (Bi2223).

2. Matériau supraconducteur selon la revendication 1, caractérisé en ce que le Bi est remplacé partiellement par du Pb.
